(19) Europäisches Patentamt
European Patent Office
Office européen des brevets

(11) **EP 3 017 496 B1**

(12) **EUROPÄISCHE PATENTSCHRIFT**

(45) Veröffentlichungstag und Bekanntmachung des Hinweises auf die Patenterteilung:
**09.09.2020 Patentblatt 2020/37**

(21) Anmeldenummer: **14735936.8**

(22) Anmeldetag: **02.07.2014**

(51) Int Cl.:
*H01M 10/42* (2006.01)   *H01M 10/44* (2006.01)
*H01M 10/48* (2006.01)   *B60L 3/12* (2006.01)
*B60L 58/16* (2019.01)   *G01R 31/367* (2019.01)
*G01R 31/382* (2019.01)  *H02J 7/00* (2006.01)

(86) Internationale Anmeldenummer:
**PCT/EP2014/064068**

(87) Internationale Veröffentlichungsnummer:
**WO 2015/000960 (08.01.2015 Gazette 2015/01)**

(54) **VERFAHREN ZUM BATTERIEMANAGEMENT UND BATTERIEMANAGEMENTSYSTEM**
METHOD FOR BATTERY MANAGEMENT AND BATTERY MANAGEMENT SYSTEM
PROCÉDÉ DE GESTION DE BATTERIE ET SYSTÈME DE GESTION DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.07.2013 DE 102013213267**

(43) Veröffentlichungstag der Anmeldung:
**11.05.2016 Patentblatt 2016/19**

(73) Patentinhaber:
• **Robert Bosch GmbH**
**70442 Stuttgart (DE)**
• **Samsung SDI Co., Ltd.**
**Yongin-si**
**Gyeonggi-do 446-577 (KR)**

(72) Erfinder:
• **TRINKERT, Stefan**
**71126 Gaeufelden (DE)**

• **LEMKE, Andreas**
**70373 Stuttgart (DE)**
• **PISCOL, Ralf**
**71083 Herrenberg (DE)**
• **LINK, Ralf**
**74676 Niedernhall (DE)**

(74) Vertreter: **Bee, Joachim**
**Robert Bosch GmbH**
**C/IPE**
**Wernerstrasse 1**
**70469 Stuttgart (DE)**

(56) Entgegenhaltungen:
EP-A1- 2 048 735    DE-A1-102010 001 529
DE-A1-102010 038 017    US-A1- 2008 304 199

EP 3 017 496 B1

**Beschreibung**

Stand der Technik

Die Erfindung betrifft ein Verfahren zum Batteriemanagement und ein Batteriemanagementsystem.

Gegenstand der Erfindung ist auch ein Computerprogramm und ein Kraftfahrzeug mit einem Batteriemanagementsystem.

In elektrisch angetriebenen Fahrzeugen wird als Energiequelle immer häufiger ein Akkumulator eingesetzt. Die Begriffe "Batterie" und "Batteriesystem" werden in der vorliegenden Beschreibung dem üblichen Sprachgebrauch angepasst für Akkumulator bzw. Akkumulatorsystem verwendet. Hierbei werden vermehrt auf Lithium basierende Akkuzellen eingesetzt, da diese derzeit die größte verfügbare Energiedichte bei geringstem Gewicht aufweisen, insbesondere im Vergleich zu auf Nickel oder Blei basierenden Akkumulatoren. Von diesen Akkumulatoren wird eine Lebensdauer von 10 Jahren oder mehr gefordert. Die Anforderungen an Akkumulatoren in Fahrzeugen sind jedoch andere als diejenigen, die an in Mobiltelefonen oder Notebooks verbaute Akkumulatoren gestellt werden. Die Akkumulatoren in Fahrzeugen sind eher vergleichbar mit Akkumulatoren im Modellbau. Damit die geforderte Lebensdauer erreicht wird, ist den Akkumulatoren üblicherweise ein so genanntes Batteriemanagementsystem zugeordnet, welches unter anderem eine Batteriezustandserkennung durchführt und ein Thermomanagement der Batterien bereitstellt.

Die Druckschrift EP 2 048 735 A1 offenbart ein Verfahren zum Batteriemanagement, wobei ein in einem Prädiktionszeitraum von der Batterie bereitstellbarer Betrag eines Stroms aus einem in dem Prädiktionszeitraum prädizierten verfügbaren Betrag einer Zustandsgröße ermittelt wird, wobei der prädizierte verfügbare Betrag der Zustandsgröße mittels einer Differenz aus einem bezüglich eines ersten Bezugszeitraumes ermittelten zulässigen Betrags der Zustandsgröße und einem bezüglich des ersten Bezugszeitraums ermittelten entnommenen Betrags der Zustandsgröße ermittelt wird.

Das erfindungsgemäße Verfahren wird in Anspruch 1 offenbart. Der von der Batterie bereitstellbare Betrag des Stroms Iv kann einem geeigneten Steuersystem der Batterie mitgeteilt werden, so dass ein Inverter dementsprechend eingestellt wird und nur diesen Strom zieht. Durch das erfindungsgemäße Verfahren werden Schäden am Akkumulator durch eine zu hohe Leistungsabgabe verhindert und eine gegebene Lebensdauergarantie der Batterie besser erfüllt. Das Batteriemanagement verhindert nicht nur mögliche Schäden durch Maximalströme an der Batterie, sondern stellt eine Optimierung der Leistungsabgabe bei bestimmten Lade- und Entladezuständen hinsichtlich der Akkuzellparameter bereit. Erfindungsgemäß sind also Überwachungsalgorithmen zur Stromregulierung vorgesehen, welche insbesondere sicherstellen, dass die Batterie im gewünschten Bereich arbeitet und altert und somit nicht vorzeitig auszutauschen ist.

Das Verfahren eignet sich insbesondere bei Batterien, die in Elektrofahrzeugen oder Hybridfahrzeugen eingesetzt werden. Die Anforderungen an diese Batterien umfassen beispielsweise, dass sie zwischen 50 V und 600 V Spannung liefern sollte. Beispiele von geeigneten Batterietypen umfassen alle Typen von Lithiumionen (zum Beispiel Lithiumeisenphosphat, Lithiumnickelmangan, Kobalt, Lithiumeisensulfid, Lithiumpolymer, Bleisäure, weiterentwickelte Bleisäure, Nickelmetallhydrid, Nickelcadmium, Zinkbromid, Natriumnickelchlorid, Zinkluft oder Lithiumluft). Bei Anwendung des Verfahrens wird insbesondere zum einen die Entwicklung eines schädigenden Temperaturgradienten in der Batterie verhindert und zum anderen auch die Ablagerung der Ionen im Ladefall, was im Falle von Lithiumionen also sogenanntes Lithium-Plating bekannt ist.

Durch die in den abhängigen Ansprüchen aufgeführten Maßnahmen sind vorteilhafte Weiterbildungen und Verbesserungen des im unabhängigen Anspruch angegebenen Verfahrens möglich.

Als Zustandsgröße, deren verfügbarer Betrag $K_R$ zur Berechnung des bereitstellbaren Betrags des Stroms Iv herangezogen wird, eignet sich beispielsweise die elektrische Energie. Es hat sich aber gezeigt, dass die Überwachung einer anderen Zustandsgröße als der Energie sich besonders gut für die angegebenen Zwecke eignet und zudem leicht messbar ist.

Die Zustandsgröße ist bevorzugt eine im weiteren Sinne energieartige Zustandsgröße und weist in einem geeigneten Ohmschen Modell der Batterie die Einheit J/$\Omega$ auf. Der in dem Prädiktionszeitraum $\Delta t$ bereitstellbare Betrag des Stroms Iv wird dabei durch Bilden eines Quotienten aus dem bereitstellbaren Betrag der Zustandsgröße Iv und dem Prädiktionszeitraum $\Delta t$ und anschließendem Wurzelziehen ermittelt, d. h. es besteht ein physikalischer Zusammenhang zwischen der bevorzugt verwendeten Zustandsgröße und dem Strom gemäß

$$K = I^2 t,$$

wobei K die Zustandsgröße bezeichnet, I der Strom in A gemessen und t die Zeit in s gemessen bezeichnen. Die Messungen des Batteriestroms I und der Zeit können kostengünstig bewerkstelligt werden und werden in vielen Batteriemanagementsystemen serienmäßig bereitgestellt. Gegenüber einer Überwachung und Bilanz auf Energiebasis entfällt je nach Modellbild, das der Batterie zugrunde gelegt wird, im Ohmschen Fall beispielsweise die Betrachtung des im Allgemeinen komplexen, temperatur-, zeit- und stromabhängigen Widerstands der Batterie, dessen Ermittlung gegebenenfalls zusätzliche Messvorrichtungen erfordert oder die Betrachtung einer Kapazität.

Der Prädiktionszeitraum ist ein bestimmter Zeitraum zwischen 2 s und 200 s, bevorzugt zwischen 5 s und 100 s, beispielsweise 10 s oder 20 s. Der erste Bezugszeitraum, in dem der zulässige und der entnommene Betrag der Zustandsgröße ermittelt wird, ist bevorzugt größer als der Prädiktionszeitraum festgelegt, beispielsweise ein bestimmter Zeitraum zwischen 5 s und 1000 s, bevorzugt zwischen 10 s und 200 s, insbesondere 100 s oder 150 s. Je größer der erste Bezugszeitraum ist, desto verlässlicher kann die Prädiktion des bereitstellbaren Stroms erfolgen. Umgekehrt ist aber auch eine gewisse Wärmedissipation in den Batteriezellen zu berücksichtigen, so dass der Einfluss einer starken Beanspruchung der Batterie, d. h. insbesondere ein hoher Stromfluss über einen bestimmten Zeitraum, nach einer bestimmten Zeit nicht mehr von Bedeutung ist. Ein Zeitraum zwischen 10 s und 200 s der Überwachung und zwischen 5 s und 20 s der Prädiktion stellen hierbei eine sinnvolle Lösung dar.

Erfindungsgemäß wird der prädizierte verfügbare Betrag $K_R$ der Zustandsgröße um einen Betrag $K_N$ einer bezüglich eines zweiten Bezugszeitraums $t_2$ ermittelten entnommenen Zustandsgröße vergrößert. Der zweite Bezugszeitraum $t_2$ weist dabei bevorzugt in etwa die Größe des Prädiktionszeitraums $\Delta t$ auf und beginnt zu Beginn des ersten Bezugszeitraums $t_1$. Hat zu Beginn des ersten Bezugszeitraums $t_1$, welcher zur Ermittlung des zulässigen und der entnommenen Betrags der Zustandsgröße maßgeblich ist, etwa ein Beschleunigungsereignis stattgefunden, dass eine gewisse Zeitdauer angedauert hat, gefolgt von sehr niedrigem Leistungsbedarf, so erhöht sich der prädizierte verfügbare Betrag der Zustandsgröße nach der gewissen Zeitdauer stark und es kann effektiv ein größerer Strom bereitgestellt werden.

Nach einer Weiterbildung der Erfindung wird ein Vorsichtsgrenzstrom $I_{lim}$ bereitgestellt, der aus einem Produkt des im Prädiktionszeitraum $\Delta t$ bereitstellbaren Stroms Iv mit einer weiteren Funktion ermittelt wird, wobei die weitere Funktion von einem Verhältnis k des entnommenen Betrags K der Zustandsgröße zum zulässigen Betrag $K_{max}$ der Zustandsgröße abhängt. Der Wert des Vorsichtsgrenzstroms kann einem geeigneten Steuersystem der Batterie mitgeteilt werden, so dass der Inverter dementsprechend eingestellt wird und nur diesen Strom zieht. Die Begrenzung des Stroms auf den Vorsichtsgrenzstrom verhindert noch stärker eine beschleunigte Alterung und erlaubt trotzdem eine homogene Leistungsabgabe.

Besonders vorteilhaft ist, wenn die weitere Funktion unterhalb einer kritischen Schwelle des Verhältnisses k des entnommenen Betrags K der Zustandsgröße zum zulässigen Betrag $K_{max}$ der Zustandsgröße im Wesentlichen konstant, beispielsweise gleich Eins, ist und oberhalb der kritischen Schwelle monoton fällt. Die kritische Schwelle ist eine bestimmte Zahl zwischen 0 und 1, bevorzugt zwischen 0,3 und 0,7 oder zwischen 0,4 und 0,6, besonders bevorzugt in etwa bei 0,5. Unterhalb der kritischen Schwelle ist der entnommene Betrag der Zustandsgröße noch viel geringer als der zulässige Betrag der Zustandsgröße, so dass die Strombegrenzung nicht verstärkt werden muss. Oberhalb der kritischen Schwelle, wenn also der entnommene Betrag der Zustandsgröße in die Nähe des zulässigen Betrags der Zustandsgröße gelangt, wird der Strom stärker begrenzt, und zwar umso stärker, je größer das Verhältnis der Beträge zueinander ist. Die Eigenschaft monoton fallend kann beispielsweise durch ein linear abfallendes Verhalten der weiteren Funktion oberhalb der kritischen Schwelle erreicht werden. Mit der einstellbaren kritischen Schwelle wird ein weiterer Parameter für das aktive Temperaturmanagement der Batterie bereitgestellt.

Erfindungsgemäß wird weiterhin ein Computerprogramm vorgeschlagen, gemäß dem eines der hierin beschriebenen Verfahren durchgeführt wird, wenn das Computerprogramm auf einer programmierbaren Computereinrichtung ausgeführt wird. Bei dem Computerprogramm kann es sich beispielsweise um ein Modul zur Implementierung eines Batteriemanagementsystems oder eines Subsystems hiervon in einem Fahrzeug handeln. Das Computerprogramm kann auf einem maschinenlesbaren Speichermedium gespeichert sein, etwa auf einem permanenten oder wiederbeschreibbaren Speichermedium oder in Zuordnung zu einer Computereinrichtung oder auf einer entfernbaren CD-ROM, DVD oder einem USB-Stick. Zusätzlich oder alternativ kann das Computerprogramm auf einer Computereinrichtung wie etwa auf einem Server oder einem Cloud-System zum Herunterladen bereitgestellt werden, zum Beispiel über ein Datennetzwerk wie das Internet oder eine Kommunikationsverbindung wie etwa eine Telefonleitung oder eine drahtlose Verbindung.

Erfindungsgemäß ist außerdem ein Batteriemanagementsystem vorgesehen, welches Diagnosesensoren zur Bereitstellung von Informationen über Temperaturen und Ströme einer Batterie, ein Modul zur Ermittlung eines bezüglich eines bezüglich eines ersten Bezugszeitraums $t_1$ zulässigen Betrags $K_{max}$ einer Zustandsgröße, ein Modul zur Ermittlung eines bezüglich des ersten Bezugszeitraums $t_1$ entnommenen Betrags K der Zustandsgröße, ein Modul zur Ermittlung eines prädizierten verfügbaren Betrags $K_R$ der Zustandsgröße aus dem zulässigen Betrag $K_{max}$ der Zustandsgröße und dem entnommenen Betrag K der Zustandsgröße und ein Modul zur Ermittlung eines bereitstellbaren Betrags eines Stroms Iv aus dem in dem Prädiktionszeitraum $\Delta t$ prädizierten verfügbaren Betrag $K_R$ der Zustandsgröße vorgesehen, welches sich insbesondere zur Ausführung eines der oben beschriebenen Verfahren eignet.

Nach einem weiteren Aspekt der Erfindung umfasst ein Kraftfahrzeug mit einem elektrischen Antriebsmotor zum Antreiben des Kraftfahrzeugs und einer mit dem elektrischen Antriebsmotor verbundenen Batterie ein derartiges Batteriemanagementsystem. Das Batteriemanagementsystem kann aber auch Teil eines akku-betriebenen elektrischen Geräts sein, insbesondere in Werkzeugen wie Akkuschraubern, Bohrmaschinen oder auch in Mobiltelefonen oder Notebooks verwendet werden.

Vorteile der Erfindung

Mit der erfindungsgemäß vorgeschlagenen Lösung wird ein Verfahren zum Batteriemanagement dargestellt, welches ein Batteriemanagement nicht nur im Hinblick auf mögliche Schäden durch Maximalströme in den Fokus rückt. Das Management und die Optimierung der Leistungsabgabe bei bestimmten Lade- und Fahrzuständen hinsichtlich der Parameter der Batteriezellen, wird durch die erfindungsgemäß vorgeschlagene Lösung im Management neben die Berücksichtigung von Maximalströmen für Batteriezellen und damit einhergehende Schäden berücksichtigt. Die mit der erfindungsgemäß vorgeschlagenen Lösung angegebenen Überwachungsalgorithmen dienen der Stromregulierung, und stellen sicher, dass die Batterie bzw. die Batteriezellen oder ein mehrerer Batteriezellen umfassendes Batteriepack in gewünschtem Bereich arbeitet und daher auch möglichst wenig altert, so dass ein vorzeitiger Austausch von Batteriezellen bzw. des Batteriezellenpacks bei Betrieb und dem erfindungsgemäß vorgeschlagenen Verfahren vermieden werden kann.

Durch das erfindungsgemäß vorgeschlagenen Verfahren kann in vorteilhafter Weise erreicht werden, dass das Batteriemanagementsystem mittels der vorgeschlagenen Algorithmen sicherstellt, dass ein Betrieb des Fahrzeugs sowie des Akkumulators innerhalb optimaler Grenzen stattfindet und gegebenenfalls eine angeforderte Leistung des Fahrers nicht abgerufen wird.

Kurze Beschreibung der Zeichnungen

Ausführungsbeispiele sind in den Zeichnungen dargestellt und in der nachfolgenden Beschreibung näher erläutert.

Es zeigen

Fig. 1    eine schematische Darstellung eines Fahrzeugkontrollsystems,

Fig. 2    einen zeitlichen Verlauf eines Stroms in einer Batterie und

Fig. 3    einen Verlauf einer Begrenzungsfunktion.

Ausführungsformen der Erfindung

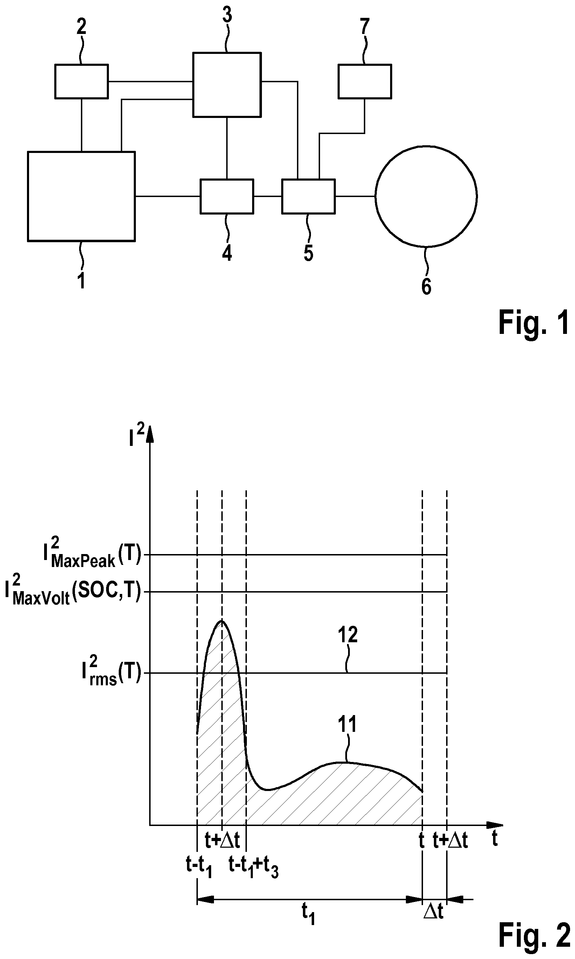

In Fig. 1 ist eine schematische Darstellung eines Fahrzeugkontrollsystems gegeben. Ein Akkumulator 1 ist über eine Trenneinrichtung 4 (BDU, battery disconnect unit) und einen Inverter 5 mit einem Motor 6 verbunden. Der Akkumulator 1 kann einzelne Batteriezellen umfassen, die beispielsweise in Serie zueinander geschaltet sind, eine Mehrzahl von Batteriemodulen umfassen, die eine einzelne oder eine Mehrzahl von in Serie und/oder parallel verschaltete Batteriezellen aufweisen oder auch eine Einzahl oder Mehrzahl von Batteriemodulsträngen aufweisen, in welchen einzelne oder eine Mehrzahl von Batteriemodulen in Serie und/oder parallel verschaltet sind. Der Akkumulator 1 wird überwacht von einem Batteriemanagementsystem 3 (BMS), welches über Diagnosesensoren beispielsweise Informationen über Ströme, Spannungen und Temperaturen in der Batterie erhält und ein Kühlsystem 2 kontrolliert. Das Gaspedal 7 des Fahrzeugs ist mit dem Inverter 5 verbunden und gibt den Leistungsbedarf an.

Die Wirkungsweise der Erfindung besteht nun darin, dass das Batteriemanagementsystem 3 mittels eines Algorithmus sicherstellt, dass eine Operation des Fahrzeugs und des Akkumulators 1 innerhalb der optimalen und erfindungsgemäßen Grenzen stattfindet, gegebenenfalls durch Nichterfüllung der Leistungsvorgaben des Gaspedals 7.

Fig. 2 zeigt beispielhaft einen zeitlichen Verlauf 11 des Quadrats eines Stroms $I^2(t)$, der beispielsweise von dem in Fig. 1 dargestellten Akkumulator 1 bereitgestellt wurde. Eine Grenzbedingung für den Stromfluss beim Laden und beim Entladen ist

$$|I(t)| < |IMaxPeak(T)|,$$

d. h. der Maximalwert des Stroms I(t) muss immer unter dem temperaturabhängigen Maximalwert $I_{MaxPeak}(T)$ liegen. Eine weitere Bedingung lautet

$$|I(t)| < |IMaxVolt(SOC,T)| \,,$$

d. h. der Maximalwert des Stroms I(t) muss sowohl bei der Ladung als auch bei der Entladung immer unter dem temperaturabhängigen und SOC-abhängigen Maximalwert $I_{MaxVolt}(SOC, T)$ liegen. Dieser Grenzwert berücksichtigt den inneren Widerstand der Batterie und sichert den Verbleib innerhalb der Spannungsgrenzen.

In Figur 2 beginnt ein erster Bezugszeitraum $t_1$ bei einem Zeitpunkt $t-t_1$ und endet bei einem Zeitpunkt t. Ein im ersten Bezugszeitraum $t_1$ entnommener Betrag K einer Zustandsgröße wird gemäß

$$K = \int_{t-t_1}^{t} I^2(t')dt'$$

von einem geeigneten Modul des Batteriemanagementsystems durch eine Integration des zeitlichen Verlaufs 11 des Stroms I (t) über den ersten Bezugszeitraum $t_1$ ermittelt. Die Ermittlung dieser wie auch der weiteren Größen kann durch Hardwarekomponenten erfolgen und/oder Berechnungen von Softwarekomponenten insbesondere solchen des BMS einbeziehen.

Eine zweite Kurve 12 zeigt den Verlauf eines Quadrats eines temperaturabhängigen lebensdaueroptimierten Grenzwerts des Stroms $I^2_{rms}(T)$ über den ersten Bezugszeitraum $t_1$ von $t-t_1$ bis t. Die temperaturabhängige lebensdaueroptimierte oberen Grenze des Stroms $I_{rms}(T)$ wird hier als konstant über die Zeit angenommen, d. h. insbesondere werden Temperaturschwankungen nicht berücksichtigt, und wird zur Ermittlung eines zulässigen Betrags $K_{max}$ der Zustandsgröße gemäß

$$K_{max} = I^2_{rms}(T) \, t_1$$

verwendet. Der zulässige Betrag $K_{max}$ der Zustandsgröße wird also durch ein Quadrat des temperaturabhängigen lebensdaueroptimierten Stromwerts $I^2_{rms}(T)$ ermittelt, das mit dem ersten Bezugszeitraum $t_1$ multipliziert wird.

Bei der Ladung muss K kleiner sein als der Grenzwert $K_{max}$. Ähnliches gilt für die Entladung, wobei der Bezugszeitraum $t_1$ bei der Ladung verschieden sein kann von dem Bezugszeitraum $t_1$ bei der Entladung. Die unterschiedlichen Werte für den Lade- bzw. Entladevorgang basieren auf den unterschiedlichen chemischen Prozessen.

Der prädizierte verfügbare Betrag $K_R$ der Zustandsgröße wird mittels der Differenz aus dem bezüglich des ersten Bezugszeitraums $t_1$ ermittelten zulässigen Betrags $K_{max}$ der Zustandsgröße und dem bezüglich des zweiten Bezugszeitraums $t_1$ ermittelten entnommenen Betrags K der Zustandsgröße ermittelt gemäß

$$K_R = t_1 \, I^2_{rms}(T) - \int_{t-t_1}^{t} I^2(t')dt'.$$

Hat zur Zeit $t-t_1$, d. h. zu Beginn des ersten Bezugszeitraums $t_1$, wie dargestellt, ein Beschleunigungsereignis stattgefunden, das in etwa eine Zeit $t_3$ gedauert hat, gefolgt von sehr niedrigem Leistungsbedarf, so erhöht sich der prädizierte verfügbare Betrag $K_R$ der Zustandsgröße in dem Prädiktionszeitraum $\Delta t$ voraussehbar sehr stark. Dies kann generell dadurch berücksichtigt werden, dass der prädizierte verfügbare Betrag $K_R$ um einen weiteren positiven Summanden

$$K_N = \int_{t-t_1}^{t-t_1+t_2} I^2(t')dt'$$

vergrößert werden kann, d. h. um einen Betrag $K_N$ der bezüglich eines zweiten Bezugszeitraums $t_2$ ermittelten entnom-

menen Zustandsgröße. Im Beispiel dargestellt und praktikabel erweist sich die Wahl des zweiten Bezugszeitraums $t_2$ in der Größe des Prädiktionszeitraums $\Delta t$, also

$$K_R = t_1 I_{rms}^2(T) - \int_{t-t1}^{t} I^2(t')dt' + \int_{t-t_1}^{t-t_1+\Delta t} I^2(t')dt'.$$

Der im Prädiktionszeitraum $\Delta t$ bereitstellbare Strom $I_V$ berechnet sich durch Bilden eines Quotienten aus dem prädizierten verfügbaren Betrag $K_R$ der Zustandsgröße und dem Prädiktionszeitraum $\Delta t$ und anschließendes Wurzelziehen gemäß

$$I_V = \sqrt{\frac{t_1 I_{rms}^2(T) - \int_{t-t_1}^{t} I^2(t')dt\prime}{\Delta t}}\quad,$$

oder unter Berücksichtigung des weiteren Summanden $K_N$ gemäß

$$I_V = \sqrt{\frac{t_1 I_{rms}^2(T) - \int_{t-t_1}^{t} I^2(t')dt' + \int_{t-t_1}^{t-t_1+\Delta t} I^2(t')dt\prime}{\Delta t}}\quad.$$

Dieser Wert kann dem Fahrzeug mitgeteilt werden, so dass der Inverter dementsprechend eingestellt wird und nur diesen auch als freigegeben bezeichnenbaren Strom zieht. Wird dieser Wert jedoch trotzdem überschritten, reagiert der Inverter also nicht den Vorgaben entsprechend, so ist eine weitere Aufgabe des erfindungsgemäßen Verfahrens zu vermeiden, dass $K_R = 0$ auftritt, da dann kein weiterer Strom fließen dürfte und sich das Fahrzeug dann nicht mehr bewegen könnte.

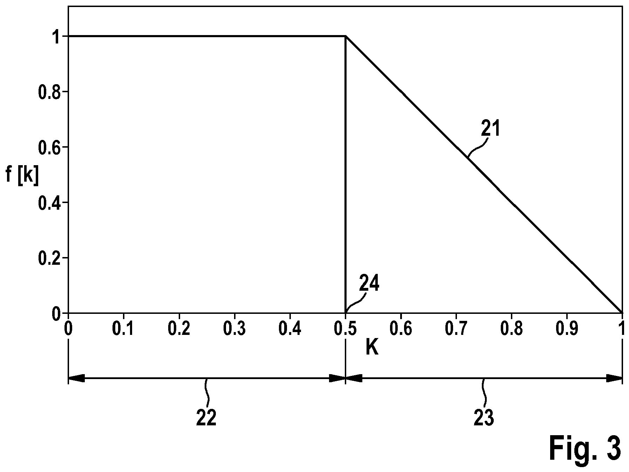

Fig. 3 zeigt den Verlauf einer Begrenzungskurve 21, welche zur Ermittlung eines Vorsichtsgrenzstroms $I_{lim}$ verwendet wird, wobei die Operation des Fahrzeugs und des Akkumulators 1 innerhalb des durch den Vorsichtsgrenzstrom angegebenen Werts stattfindet, um auch die genannte weitere Aufgabe zu lösen. Die Begrenzungskurve 21 hängt ab vom Verhältnis k des prädizierten verfügbaren Betrags der Zustandsgröße $K_R$ zum zulässigen Betrag $K_{max}$ der Zustandsgröße, d. h.

$$f(k) = f(K_R/K_{max}).$$

In einem ersten Abschnitt 22 ist die Begrenzungskurve 21 konstant Eins und fällt in einem weiteren Abschnitt 23 monoton ab, bis sie bei dem Wert k = 1, d. h. $K_R = K_{max}$, auf 0 abgefallen ist. Der erste Bereich 22 und der zweite Bereich 23 werden von einer kritischen Schwelle 24 getrennt, welche im dargestellten Beispiel bei k = 0,5 liegt. Prinzipiell kann der Verlauf der Begrenzungskurve 21 variieren. Beispielsweise muss die Begrenzungsfunktion 21 im ersten Bereich 22 nicht konstant sein, sondern kann auch hier schwanken, insbesondere leicht schwanken. Im Bereich 23 kann der abfallende Verlauf unterschiedlich gestaltet sein und muss nicht wie im dargestellten Ausführungsbeispiel linear verlaufen. Insbesondere ist ein exponentieller, ein logarithmischer oder ein polynomialer Verlauf möglich. Die kritische Schwelle 24 kann eine definierte Zahl zwischen 0 und 1 sein, insbesondere zwischen 0,4 und 0,6 und ist nur beispielhaft bei 0,5 festgelegt.

Der Vorsichtsgrenzstrom $I_{lim}$ wird aus dem Produkt des im Prädiktionszeitraum $\Delta t$ bereitgestellten Stroms $I_V$ mit der Begrenzungsfunktion 21 gebildet, insbesondere nach

$$I_{lim} = I_V f(k).$$

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

**Patentansprüche**

1. Verfahren zum Batteriemanagement, wobei ein in einem Prädiktionszeitraum ($\Delta t$) von der Batterie bereitstellbarer Betrag eines Stroms (Iv) aus einem in dem Prädiktionszeitraum ($\Delta t$) prädizierten verfügbaren Betrag ($K_R$) einer Zustandsgröße ermittelt wird, wobei der prädizierte verfügbare Betrag ($K_R$) der Zustandsgröße mittels einer Differenz aus einem bezüglich eines ersten Bezugszeitraums ($t_1$) ermittelten zulässigen Betrags ($K_{max}$) der Zustandsgröße und einem bezüglich des ersten Bezugszeitraums ($t_1$) ermittelten entnommenen Betrags (K) der Zustandsgröße ermittelt wird, wobei Folgendes gilt:

$$K = \int_{t-t_1}^{t} I^2(t')dt',$$

wobei K der entnommene Betrag der Zustandsgröße im ersten Bezugszeitraum $t_1$, der Strom in A gemessen und t die Zeit in s gemessen ist;

$$K_{max} = I^2_{rms}(T) \cdot t_1,$$

wobei $K_{max}$ der zulässige Betrag der Zustandsgröße im ersten Bezugszeitraum $t_1$ ist und $I_{rms}$ eine temperaturabhängige lebensdaueroptimierte obere Grenze des Stroms ist;

$$K_R = K_{max} - K,$$

wobei $K_R$ der prädizierte maximal verfügbare Betrag der Zustandsgröße ist,
**dadurch gekennzeichnet, dass**
der prädizierte verfügbare Betrag ($K_R$) der Zustandsgröße um einen Betrag ($K_N$) einer bezüglich eines zweiten Bezugszeitraums ($t_2$) ermittelten entnommenen Zustandsgröße vergrößert wird, wobei Folgendes gilt:

$$K_R = K_{max} - K + K_N,$$

mit

$$K_N = \int_{t-t_1}^{t-t_1+t_2} I^2(t')dt',$$

wobei $K_N$ der Betrag der bezüglich des zweiten Bezugszeitraums $t_2$ ermittelten entnommenen Zustandsgröße ist; und wobei der bereitstellbare Betrag des Stroms gemäß

$$I_V = \sqrt{\frac{K_{max} - K + K_N}{\Delta t}} = \sqrt{\frac{t_1 I^2_{rms}(T) - \int_{t-t_1}^{t} I^2(t')dt' + \int_{t-t_1}^{t-t_1+\Delta t} I^2(t')dt'}{\Delta t}}$$

bestimmt wird.

2. Verfahren nach Anspruch 1, **dadurch gekennzeichnet, dass** der zweite Bezugszeitraum ($t_2$) die Größe des Prädiktionszeitraums ($\Delta t$) aufweist und zu Beginn des ersten Bezugszeitraums ($t_1$) beginnt.

3. Verfahren nach einem der vorhergehenden Ansprüche, **dadurch gekennzeichnet, dass** der Prädiktionszeitraum ($\Delta t$) ein bestimmter Zeitraum zwischen 2 s und 200 s und/oder der erste Bezugszeitraum ($t_1$) ein bestimmter Zeitraum zwischen 5 s und 1000 sind.

4. Verfahren nach einem der vorhergehenden Ansprüche, **dadurch gekennzeichnet, dass** ein Vorsichtsgrenzstrom ($I_{lim}$) aus einem Produkt des im Prädiktionszeitraum ($\Delta t$) bereitstellbaren Stroms ($Iv$) mit einer weiteren Funktion ermittelt wird, wobei die weitere Funktion unterhalb einer definierten kritischen Schwelle (24) eines Verhältnisses ($k$) des entnommenen Betrags ($K$) der Zustandsgröße zum zulässigen Betrag ($K_{max}$) der Zustandsgröße konstant ist und oberhalb der kritischen Schwelle (24) monoton fällt.

5. Computerprogramm zur Ausführung eines der Verfahren nach einem der Ansprüche 1 bis 4, wenn das Computerprogramm auf einer programmierbaren Computereinrichtung ausgeführt wird.

6. Batteriemanagementsystem aufweisend Diagnosesensoren zur Bereitstellung von Informationen über Temperaturen und Ströme einer Batterie, ein Modul zur Ermittlung eines bezüglich eines ersten Bezugszeitraums ($t_1$) zulässigen Betrags ($K_{max}$) einer Zustandsgröße, ein Modul zur Ermittlung eines bezüglich des ersten Bezugszeitraums ($t_1$) entnommenen Betrags ($K$) der Zustandsgröße, ein Modul zur Ermittlung eines prädizierten verfügbaren Betrags ($K_R$) der Zustandsgröße aus dem zulässigen Betrag ($K_{max}$) der Zustandsgröße und dem entnommenen Betrag ($K$) der Zustandsgröße und ein Modul zur Ermittlung eines bereitstellbaren Betrags eines Stroms ($Iv$) aus dem in dem Prädiktionszeitraum ($\Delta t$) prädizierten verfügbaren Betrag ($K_R$) der Zustandsgröße gemäß einem der Ansprüche 1 bis 4 oder eines Vorsichtsgrenzstroms ($I_{lim}$) gemäß Anspruch 4.

7. Kraftfahrzeug mit einem Batteriemanagementsystem nach Anspruch 6.

**Claims**

1. Method for battery management, wherein an amount of a current ($I_V$) that can be provided by the battery in a prediction time period ($\Delta t$) is determined from an available amount ($K_R$) of a status variable predicted in the prediction time period ($\Delta t$), wherein the predicted available amount ($K_R$) of the status variable is determined by means of a difference between a permissible amount ($K_{max}$) of the status variable determined with respect to a first reference time period ($t_1$) and an obtained amount ($K$) of the status variable determined with respect to the first reference time period ($t_1$), wherein the following applies:

$$K = \int_{t-t_1}^{t} I^2(t')dt',$$

where K is the obtained amount of the status variable in the first reference time period $t_1$, I is the current measured in A and t is the time measured in s;

$$K_{max} = I^2_{rms}(T) \cdot t_1,$$

where $K_{max}$ is the permissible amount of the status variable in the first reference time period $t_1$ and $I_{rms}$ is a temperature-dependent lifetime-optimized upper limit of the current;

$$K_R = K_{max} - K,$$

where $K_R$ is the predicted maximum available amount of the status variable,
**characterized in that**

the predicted available amount ($K_R$) of the status variable is increased by an amount ($K_N$) of an obtained status variable determined with respect to a second reference time period ($t_2$), wherein the following applies:

$$K_R = K_{max} - K + K_N,$$

with

$$K_N = \int_{t-t_1}^{t-t_1+t_2} I^2(t')dt' \, ,$$

where $K_N$ is the amount of the obtained status variable determined with respect to the second reference time period $t_2$; and wherein the amount of the current that can be provided is determined according to

$$I_V = \sqrt{\frac{K_{max} - K + K_N}{\Delta t}} = \sqrt{\frac{t_1 I^2_{rms}(T) - \int_{t-t_1}^{t} I^2(t')dt' + \int_{t-t_1}^{t-t_1+\Delta t} I^2(t')dt'}{\Delta t}}$$

2. Method according to Claim 1, **characterized in that** the second reference time period ($t_2$) is the same size as the prediction time period ($\Delta t$) and begins at the beginning of the first reference time period ($t_1$).

3. Method according to either of the preceding claims, **characterized in that** the prediction time period ($\Delta t$) is a certain time period between 2 s and 200 s and/or the first reference time period ($t_1$) is a certain time period between 5 s and 1000 s.

4. Method according to one of the preceding claims, **characterized in that** a precautionary limit current ($I_{lim}$) is determined with a further function from a product of the current ($I_V$) that can be provided in the prediction time period ($\Delta t$), wherein the further function is constant below a defined critical threshold (24) of a ratio ($k$) of the obtained amount ($K$) of the status variable to the permissible amount ($K_{max}$) of the status variable and falls monotonously above the critical threshold (24).

5. Computer program for performing one of the methods according to one of Claims 1 to 4 when the computer program is run on a programmable computer device.

6. Battery management system comprising diagnostic sensors for providing information concerning temperatures and currents of a battery, a module for determining a permissible amount ($K_{max}$) of a status variable with respect to a first reference time period ($t_1$), a module for determining an amount ($K$) of the status variable obtained with respect to the first reference time period ($t_1$), a module for determining a predicted available amount ($K_R$) of the status variable from the permissible amount ($K_{max}$) of the status variable and the obtained amount ($K$) of the status variable and a module for determining an amount of a current ($I_V$) that can be provided from the available amount ($K_R$) of the status variable predicted in the prediction time period ($\Delta t$) according to one of Claims 1 to 4 or of a precautionary limit current ($I_{lim}$) according to Claim 4.

7. Motor vehicle with a battery management system according to Claim 6.

**Revendications**

1. Procédé de gestion de batterie, une valeur d'un courant ($I_V$) qui peut être mis à disposition par la batterie dans une période de prédiction ($\Delta t$) étant déterminée à partir d'une valeur disponible prédite ($K_R$) d'une grandeur d'état dans la période de prédiction ($\Delta$t), la valeur disponible prédite ($K_R$) de la grandeur d'état étant déterminée au moyen d'une différence entre une valeur admissible ($K_{max}$) de la grandeur d'état déterminée en référence à une première période de référence ($t_1$) et une valeur prélevée ($K$) de la grandeur d'état en référence à la première période de référence ($t_1$), les règles suivantes s'appliquant :

$$K = \int_{t-t_1}^{t} I^2(t')dt',$$

K désignant la valeur prélevée de la grandeur d'état dans la première période de référence $t_1$, I le courant mesuré en A et t le temps mesuré en s ;

$$K_{max} = I^2{}_{rms}(T) \cdot t_1,$$

$K_{max}$ désignant la valeur admissible de la grandeur d'état dans la première période de référence $t_1$ et $I_{rms}$ une limite haute du courant dépendante de la température et optimisée en durée de vie ;

$$K_R = K_{max} - K,$$

$K_R$ désignant la valeur disponible maximale prédite de la grandeur d'état,
**caractérisé en ce que**
la valeur disponible prédite ($K_R$) de la grandeur d'état est augmentée d'une valeur ($K_N$) d'une grandeur d'état prélevée déterminée en référence à une deuxième période de référence ($t_2$), la règle suivante s'appliquant :

$$K_R = K_{max} - K + K_N,$$

avec

$$K_N = \int_{t-t_1}^{t-t_1+t_2} I^2(t')dt',$$

$K_N$ désignant la valeur de la grandeur d'état prélevée déterminée en référence à la deuxième période de référence $t_2$ ; et la valeur du courant qui peut être mis à disposition est déterminée conformément à

$$I_V = \sqrt{\frac{K_{max} - K + K_N}{\Delta t}} = \sqrt{\frac{t_1 I^2{}_{rms}(T) - \int_{t-t_1}^{t} I^2(t')dt' + \int_{t-t_1}^{t-t_1+\Delta t} I^2(t')dt'}{\Delta t}}.$$

2. Procédé selon la revendication 1, **caractérisé en ce que** la deuxième période de référence ($t_2$) présente la taille de la période de prédiction ($\Delta$t) et commence au début de la première période de référence ($t_1$).

3. Procédé selon l'une des revendications précédentes, **caractérisé en ce que** la période de prédiction ($\Delta$t) est une période déterminée entre 2 s et 200 s et/ou la première période de référence ($t_1$) est une période déterminée entre 5 s et 1000 s.

4. Procédé selon l'une des revendications précédentes, **caractérisé en ce qu'**un courant limite de prudence ($I_{lim}$) est déterminé à partir d'un produit du courant (Iv) qui peut être mis à disposition dans la période de prédiction ($\Delta$t) avec une fonction supplémentaire, la fonction supplémentaire étant constante au-dessous d'un seuil critique (24) défini d'un rapport (k) entre la valeur prélevée ($K$) de la grandeur d'état et la valeur admissible ($K_{max}$) de la grandeur d'état et chutant de manière monotone au-dessus du seuil critique (24).

5. Programme informatique destiné à mettre en œuvre un procédé selon l'une des revendications 1 à 4 lorsque le programme informatique est exécuté sur un dispositif informatique programmable.

6. Système de gestion de batterie possédant des capteurs de diagnostic destinés à fournir des informations à propos des températures et des courants d'une batterie, un module destiné à déterminer une valeur admissible ($K_{max}$) d'une grandeur d'état en référence à une première période de référence ($t_1$), un module destiné à déterminer une valeur prélevée (K) de la grandeur d'état en référence à la première période de référence ($t_1$), un module destiné à déterminer une valeur disponible prédite ($K_R$) de la grandeur d'état à partir de la valeur admissible ($K_{max}$) de la grandeur d'état et de la valeur prélevée (K) de la grandeur d'état et un module destiné à déterminer une valeur qui peut être mise à disposition d'un courant ($I_V$) à partir de la valeur disponible prédite ($K_R$) de la grandeur d'état dans la période de prédiction ($\Delta t$) selon l'une des revendications 1 à 4 ou d'un courant limite de prudence ($I_{lim}$) selon la revendication 4.

7. Véhicule automobile comprenant un système de gestion de batterie selon la revendication 6.

**Fig. 1**

**Fig. 2**

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2048735 A1